# FASCICULE DE BREVET EUROPEEN

(11) **EP 2 240 956 B1**
(45) Date de publication et mention de la délivrance du brevet: **21.08.2013**
(21) Numéro de dépôt: 08869950.9
(22) Date de dépôt: 31.12.2008
(51) Int. Cl.: H01L 21/28, H01L 21/336, H01L 29/423, H01L 29/51, H01L 29/788, G04F 10/10, G11C 16/04, G11C 16/28, G11C 16/34, G11C 27/00, H01L 29/66, H01L 21/8247, H01L 27/115

(54) **Cellule EEPROM à perte de charges, son procédé de formation et procédé de mesure d'une information temporelle**
EEPROM-Zelle mit Ladungsverlust und Herstellungsverfahren derselben, sowie Verfahren zum Messen einer Zeit-Information
EEPROM cell with charge loss and manufacturing method thereof, and method of measuring a time information

(30) Priorité: 11.01.2008 FR 0850170
(43) Date de publication de la demande: 20.10.2010
(73) Titulaire: ST Microelectronics (Rousset) SAS, 13790 Rousset (FR)
(72) Inventeur: FORNARA, Pascal, F-83910 Pourrieres (FR)
(74) Mandataire: de Beaumont, Michel
(86) Numéro de dépôt international: PCT/FR2008/052437
(87) Numéro de publication internationale: WO 2009/087335

(56) Documents cités:
- WO-A-01/17025
- WO-A-02/069284
- US-A1- 2006 244 434
- US-B1- 6 856 581

## Description

### Domaine de l'invention

La présente invention concerne de façon générale les circuits électroniques et, plus particulièrement, la réalisation d'un circuit permettant de retenir des charges électriques de façon contrôlable pour une mesure temporelle.

### Exposé de l'art antérieur

Dans de nombreuses applications, on souhaite disposer d'une information représentative d'un temps écoulé entre deux événements, qu'il s'agisse d'une mesure précise ou approximative. Un exemple d'application concerne la gestion temporelle de droits d'accès, notamment à des médias.

L'obtention de cette information représentative du temps écoulé requiert habituellement une mesure temporelle par un circuit électronique alimenté, par exemple au moyen d'une batterie, afin de ne pas perdre l'évolution de l'information lorsque le circuit n'est pas utilisé.

Il serait souhaitable de disposer d'une mesure temporelle qui fonctionne même lorsque le circuit électronique de mesure n'est pas alimenté.

La demande internationale WO-A-03/083769 décrit une entité électronique transactionnelle sécurisée par mesure du temps, dans laquelle le temps qui s'écoule entre deux transactions successives est déterminé en mesurant la charge d'un composant capacitif présentant une fuite de son espace diélectrique. Le composant est chargé lorsque le circuit est alimenté et sa charge résiduelle, après une interruption de l'alimentation, est mesurée lorsque le circuit est de nouveau alimenté. Cette charge résiduelle est considérée comme représentative du temps écoulé entre les deux instants d'alimentation du circuit.

L'entité électronique est basée sur un transistor MOS dont la grille est connectée à une première électrode d'un composant capacitif dont l'autre électrode est reliée à la masse avec la source du transistor. Le drain du transistor est connecté à une tension d'alimentation au moyen d'une résistance de conversion courant-tension. La tension mesurée aux bornes de la résistance est fonction du courant de drain dans le transistor, donc de sa tension grille-source, donc de la tension aux bornes du composant capacitif. Un intervalle temporel est initialisé en chargeant le composant capacitif par application d'une source d'énergie électrique sur son électrode commune à la grille du transistor.

La solution proposée par ce document présente plusieurs inconvénients.

Tout d'abord, la plage temporelle mesurable est limitée par les possibilités d'intervention sur le diélectrique du composant capacitif.

Ensuite, la charge du composant capacitif engendre une contrainte électrique sur son diélectrique (stress) de sorte que les mesures dérivent dans le temps.

Par ailleurs, la structure proposée requiert la réalisation d'un composant spécifique. Dans certaines applications, il serait souhaitable d'associer l'élément de mesure temporelle à une mémoire pour conditionner l'accès aux données ou programmes contenus dans cette mémoire. La solution du document susmentionné est difficilement compatible avec des étapes de fabrication de mémoires.

En outre, l'interprétation de la charge résiduelle dans le composant capacitif nécessite des étapes de calibration pour générer des tables de conversion charge-temps.

Les documents US 2006/0244434, US 6856581, WO 01/17025 et WO 02/069284 décrivent des cellules mémoire EEPROM utilisées pour réaliser des mesures temporelles.

### Résumé de l'invention

L'invention est définie par les dispositifs des revendications 1 et 3 et par les procédés des revendications 5 et 6. Un mode de réalisation vise à pallier tout ou partie des inconvénients des solutions connues pour fournir une information représentative d'un temps écoulé entre deux événements, sans qu'il soit nécessaire que le circuit électronique contenant les moyens pour y parvenir soit alimenté en permanence.

Un mode de réalisation vise un circuit électronique de rétention de charges pour une mesure temporelle.

Un mode de réalisation vise la réalisation d'un tel circuit compatible avec les technologies utilisées pour la réalisation de cellules mémoire.

Un mode de réalisation vise un procédé de formation d'une cellule mémoire EEPROM à perte de charges contrôlable.

Pour atteindre tout ou partie de ces objets ainsi que d'autres, il est prévu une cellule mémoire EEPROM comprenant un transistor MOS à double grille dont les deux grilles sont séparées par une couche isolante, la couche isolante étant constituée d'une première portion et d'une seconde portion moins isolante que la première portion, la seconde portion étant située, au moins en partie, au-dessus d'une région de canal du transistor.

Selon un mode de réalisation, la première portion de la couche isolante est constituée d'un empilement d'une première couche d'oxyde de silicium, d'une couche de nitrure de silicium et d'une seconde couche d'oxyde de silicium, la seconde portion de la couche isolante étant constituée d'une troisième couche d'oxyde de silicium.

Un mode de réalisation prévoit un circuit électronique de rétention de charges pour une mesure temporelle, implanté dans un réseau de cellules mémoire de type EEPROM comportant chacune un transistor de sélection en série avec un transistor à double grille comportant, sur une même rangée de cellules mémoire : un premier sous-ensemble formé d'au moins une cellule telle que définie précédemment ; et un deuxième sous-ensemble d'au moins une deuxième cellule dont la fenêtre tunnel du transistor à double grille est supprimée, les grilles flottantes des transistors à double grille des cellules des deux sous-ensembles étant connectées à un noeud flottant.

Selon un mode de réalisation, le circuit comprend en outre un troisième sous-ensemble d'au moins une troisième cellule, la grille flottante du transistor à double grille de la troisième cellule étant connectée au noeud flottant, le troisième sous-ensemble servant à injecter ou extraire des charges du noeud flottant dans une phase de programmation ou de réinitialisation.

Selon un mode de réalisation, la mesure d'une information temporelle est obtenue en évaluant la charge résiduelle du noeud flottant à partir du courant dans le transistor à double grille du deuxième sous-ensemble.

Un mode de réalisation prévoir un procédé de formation d'une cellule mémoire EEPROM comprenant un transistor à double grille de silicium polycristallin comportant, après une étape de formation d'une première grille et avant une étape de formation d'une seconde grille, les étapes successives suivantes : former, sur la première grille, une première couche de matériau isolant ; former, dans la première couche de matériau isolant, une ouverture ; former, dans l'ouverture et sur la première grille, une seconde couche de matériau isolant, la seconde couche étant moins isolante que la première couche isolante.

Selon un mode de réalisation, la première couche de matériau isolant est constituée d'un empilement d'une première couche d'oxyde de silicium, d'une couche de nitrure de silicium et d'une seconde couche d'oxyde de silicium, et la seconde couche de matériau isolant est constituée d'une troisième couche d'oxyde de silicium.

### Brève description des dessins

Ces objets, caractéristiques et avantages, ainsi que d'autres seront exposés en détail dans la description suivante de modes de mises en oeuvre et de réalisations particuliers faite à titre non-limitatif en relation avec les figures jointes parmi lesquelles :
la figure 1 est un schéma électrique d'une cellule EEPROM ;
les figures 2A et 2B illustrent, selon deux plans de coupe perpendiculaires, la structure de la cellule de la figure 1 ;
la figure 3 représente, de façon très schématique et sous forme de blocs, une entité électronique équipée d'un circuit de rétention de charges selon un mode de réalisation ;
la figure 4 est un schéma fonctionnel d'un mode de réalisation d'un circuit électronique de rétention de charges ;
la figure 5 est un schéma fonctionnel d'un autre mode de réalisation d'un circuit électronique de rétention de charges ;
la figure 6 est un schéma électrique d'un mode de réalisation d'un circuit électronique de rétention de charges ;
les figures 7A, 7B et 7C sont, respectivement, une vue de dessus, une vue en coupe et le schéma électrique équivalent d'un premier élément du circuit de la figure 6 ;
les figures 8A, 8B et 8C sont, respectivement, une vue de dessus, une vue en coupe et le schéma électrique équivalent d'un deuxième élément du circuit de la figure 6 ;
les figures 9A, 9B et 9C sont respectivement une vue de dessus, une vue en coupe et le schéma électrique équivalent d'un troisième élément du circuit de la figure 6 ;
les figures 10A à 10J et 11A à 11J illustrent, respectivement en vues en coupe selon une première et une deuxième direction, des résultats d'étapes d'un procédé de fabrication de la structure des figures 9A à 9C ;
la figure 12 représente un mode de réalisation d'un circuit de lecture d'un circuit de rétention de charges ;
la figure 13 représente partiellement un autre mode de réalisation d'un circuit de lecture d'un circuit de rétention de charges ;
la figure 14 représente un exemple de convertisseur numérique-analogique non linéaire utilisable dans un circuit de lecture d'un circuit de rétention de charges ;
les figures 15A et 15B sont des chronogrammes illustrant un mode de fonctionnement d'un circuit de lecture d'un circuit de rétention de charges ;
les figures 16A et 16B sont des chronogrammes illustrant une variante d'un mode de fonctionnement d'un circuit de lecture d'un circuit de rétention de charges ;
les figures 17A et 17B sont des chronogrammes illustrant un mode de mise en oeuvre d'un procédé de caractérisation d'un circuit de lecture ;
les figures 18A et 18B sont des chronogrammes illustrant un autre mode de mise en oeuvre d'un procédé de caractérisation du circuit de lecture ; et
la figure 19 représente, partiellement et schématiquement, une variante du circuit de lecture compatible avec le procédé de caractérisation des figures 17A, 17B, 18A et 18B.

De mêmes éléments ont été désignés par de mêmes références aux différentes figures qui ont été tracées sans respect d'échelle. Par souci de clarté, seuls les éléments et étapes utiles à la compréhension de l'invention ont été représentés et seront décrits. En particulier, l'utilisation faite de l'information temporelle obtenue n'a pas été détaillée, l'invention étant compatible avec toute exploitation habituelle d'une telle information temporelle. De même, les procédés et éléments à l'origine d'une programmation ou initialisation de décompte temporel n'ont pas été détaillés, l'invention étant là encore compatible avec tout besoin de déclenchement d'un décompte temporel.

### Description détaillée

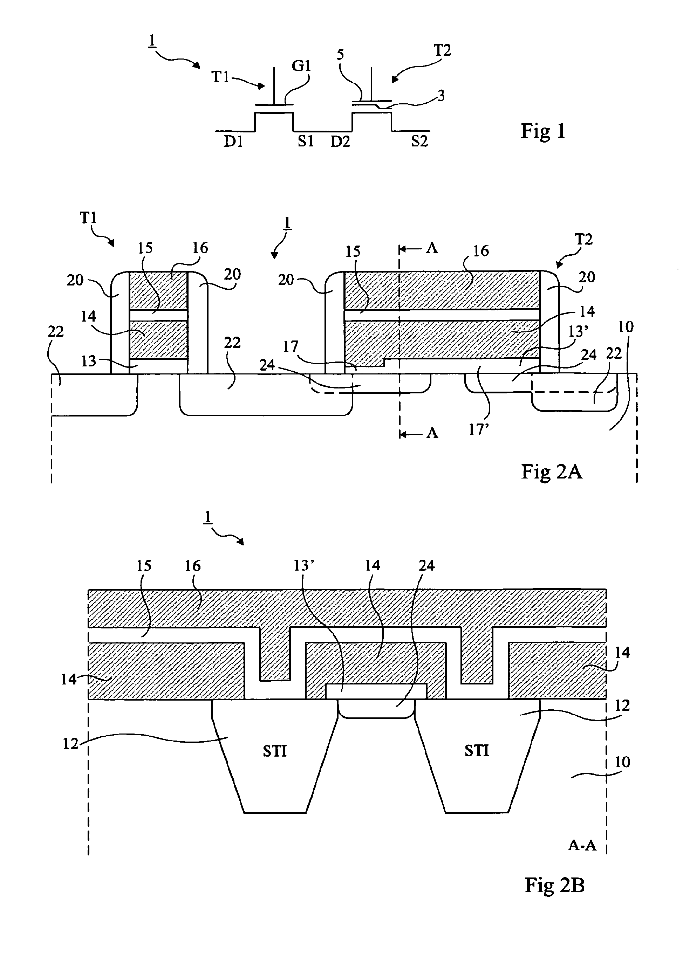

La figure 1 est un schéma électrique d'une cellule mémoire 1 constitutive des mémoires EEPROM. La cellule mémoire 1 est constituée d'un transistor de lecture T1 et d'un point mémoire T2. Le transistor T1 est un transistor MOS comportant un drain D1, une source S1 et une grille isolée G1. Le point mémoire T2 est de type à double grille. Il comporte un drain D2, une source S2, et deux grilles isolées, à savoir une grille flottante 3 et une grille de commande 5. On considère ici un point mémoire T2 dont l'isolant de grille flottante comporte au moins une partie suffisamment mince pour permettre un passage, par effet tunnel, de porteurs entre le canal sous-jacent et la grille flottante. L'isolant de la grille flottante 3 est appelé "isolant tunnel" ou "oxyde tunnel". La source S1 du transistor T1 est reliée au drain D2 du point mémoire T2.

Les figures 2A et 2B illustrent, selon deux plans de coupe perpendiculaires, la structure d'une cellule mémoire 1 du type de celle de la figure 1.

La cellule 1 est formée dans une région active d'un substrat semiconducteur 10, typiquement en silicium monocristallin, délimitée latéralement par des zones d'isolement de champ 12 (STI, figure 2B).

Au-dessus du substrat semiconducteur 10 sont formées les structures de grille du transistor T1 et du point mémoire T2. La grille du transistor T1 est composée d'un empilement d'une première portion isolante 13, d'une première portion conductrice 14, d'une seconde portion isolante 15 et d'une seconde portion conductrice 16. Il peut être souhaitable que le fonctionnement du transistor T1 soit similaire à celui d'un transistor MOS classique à grille unique. Pour ce faire, on peut prévoir une ouverture dans la portion isolante 15 de façon que les portions 14 et 16 soient court-circuitées. La grille du point mémoire T2 est formée d'un empilement 13'-14-15-16 dont les portions 14, 15 et 16 sont similaires à celles du transistor T1. La couche conductrice 14 forme la grille flottante du point mémoire T2 et la couche conductrice 16 forme la grille de commande de ce point mémoire. La portion isolante 13' comporte une partie relativement épaisse 17' formant la partie non tunnel de l'isolant de la grille flottante 14 et une partie relativement mince 17 constituant la zone d'oxyde tunnel. La portion d'oxyde 17 plus fine que la portion 17' s'étend sur toute la largeur de la zone active jusqu'au dessus des zones d'isolation de champ 12. Des espaceurs 20 sont formés de part et d'autre du transistor T1 et du point mémoire T2.

Les couches conductrices 14 et 16 sont, par exemple, en silicium polycristallin d'une épaisseur, respectivement, d'environ 100 nm et d'environ 200 nm et les portions isolantes 17 et 17' sont en oxyde, par exemple en oxyde de silicium (SiO₂). La couche isolante 15 est typiquement formée d'un empilement oxyde-nitrure-oxyde (empilement "ONO") d'une épaisseur totale d'environ 180 nm. A titre d'exemple, dans l'empilement ONO, l'oxyde peut être de l'oxyde de silicium et le nitrure du nitrure de silicium.

De part et d'autre du transistor T1 et du point mémoire T2, des zones d'implantation 22 de drain et de source du transistor T1 et de drain et de source du point mémoire T2 sont formées dans le substrat de silicium 10 (les régions de source du transistor T1 et de drain du point mémoire T2 se rejoignent). Deux autres zones d'implantation 24 sont formées de part et d'autre du point mémoire T2 en surface du substrat 10, en partie en dessous de la portion isolante 13'.

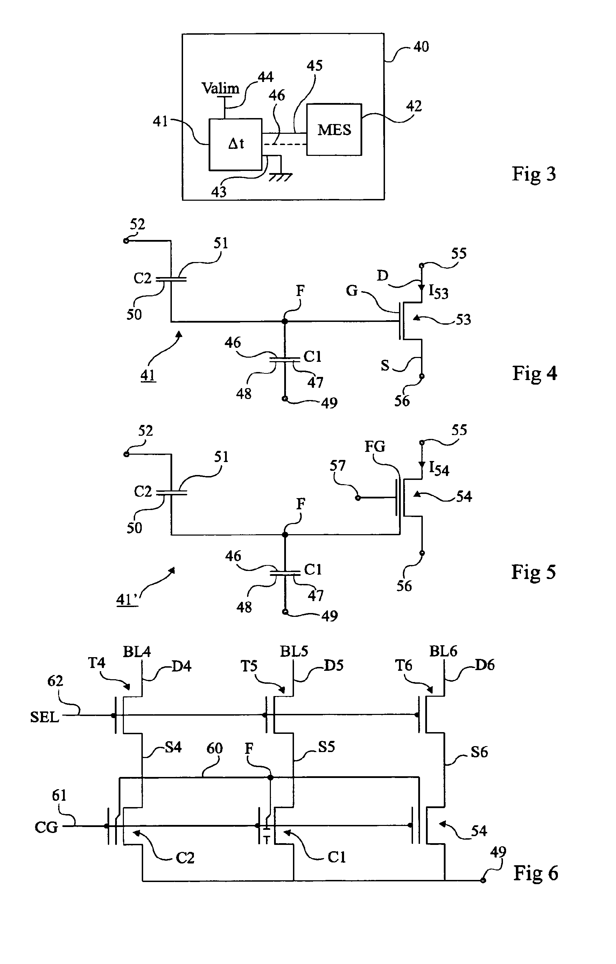

La figure 3 représente, de façon très schématique et sous forme de blocs, un dispositif électronique 40 comportant un circuit électronique de rétention de charges 41.

Le dispositif 40 est un dispositif électronique quelconque susceptible d'exploiter une information représentative d'un temps écoulé entre deux événements. Il est équipé d'un circuit 41 (Δt) de rétention de charges contrôlable pour une mesure temporelle. Le circuit 41 est susceptible d'être soumis à une tension d'alimentation Valim appliquée entre deux bornes 43 et 44, la borne 43 étant reliée à un potentiel de référence (par exemple la masse). La tension Valim sert à initialiser une phase de rétention de charges. Deux bornes 45 et 46 du circuit 41 sont destinées à être reliées à un circuit de mesure 42 (MES) capable de transformer une information sur une charge résiduelle d'un élément du circuit 41 en une information relative au temps écoulé entre l'instant d'initialisation de la phase de rétention et l'instant de mesure. La borne 46 peut servir de référence à la mesure et être connectée à la masse. Le circuit 41 est préférentiellement intégré à partir d'un substrat semiconducteur, par exemple en silicium.

La figure 4 représente un mode de réalisation d'un circuit électronique de rétention de charges 41.

Le circuit 41 comporte un premier élément capacitif C1 dont une première électrode 46 est connectée à un noeud flottant F et dont l'espace diélectrique 47 est conçu pour présenter des fuites non négligeables dans le temps. Par noeud flottant F, on entend un noeud non directement connecté à une quelconque région diffusée du substrat semiconducteur et, plus particulièrement, séparé, par un espace diélectrique, de toutes bornes d'application de potentiel. La deuxième électrode 48 de l'élément capacitif C1 est reliée à une borne 49 qui est connectée à un potentiel de référence ou laissée en l'air.

De préférence, un deuxième élément capacitif C2 a une première électrode 50 connectée au noeud F et une deuxième électrode 51 connectée à une borne 52 du circuit destinée à être connectée à une source d'alimentation (par exemple la tension Valim) lors d'une initialisation d'une phase de rétention de charges.

L'élément capacitif C1 a pour rôle de stocker une charge électrique puis de se décharger relativement lentement grâce à la fuite à travers son espace diélectrique. L'élément capacitif C2 a pour rôle de permettre une injection de charges dans l'élément capacitif C1 par effet Fowler-Nordheim ou par un phénomène d'injection d'électrons chauds. L'élément C2 permet d'éviter les contraintes (stress) sur l'élément C1 lors de sa charge.

Le noeud F est relié à une grille G d'un transistor à borne de commande isolée (par exemple un transistor MOS 53) dont les bornes de conduction (drain D et source S) sont connectées, respectivement, à des bornes de sortie 55 et 56 pour mesurer la charge résiduelle contenue dans l'élément C1. Par exemple, la borne 56 est reliée à la masse et la borne 55 est reliée à une source de courant permettant une conversion courant-tension du courant de drain I₅₃ dans le transistor 53.

La figure 5 représente un autre mode de réalisation d'un circuit 41' de rétention de charges contrôlable. Par rapport au mode de réalisation de la figure 4, le transistor 53 est remplacé par un transistor 54 à double grille dont la grille flottante FG est reliée au noeud F. La grille de commande du transistor 54 est reliée à une borne 57 de commande en lecture de la charge résiduelle dans le circuit. De la même façon que dans le circuit de la figure 4, la borne 56 peut être reliée à la masse et la borne 55 reliée à une source de courant permettant une conversion courant-tension du courant de drain I₅₄ dans le transistor 54.

L'évaluation du courant de drain I₅₄, représentatif de la tension aux bornes de l'élément capacitif C1, peut être effectuée en maintenant les bornes 49 et 56 au même potentiel (par exemple, la masse) et en appliquant une tension continue sur la borne 55. On peut également appliquer des potentiels de référence différents sur les bornes 49 et 56, comme on le verra par la suite.

L'intervalle de temps entre l'instant où la tension Valim cesse d'être appliquée sur la borne 52 et l'instant où la charge au noeud F s'annule dépend non seulement de la capacité de fuite du diélectrique de l'élément C1, mais également de sa capacité de stockage qui conditionne la charge présente au noeud F à l'arrêt de l'application de Valim sur la borne 52. Il est donc possible de définir une corrélation entre la charge résiduelle (par rapport à la charge initiale) et le temps passé après une phase de réinitialisation du circuit.

En supposant que les bornes 49 et 56 sont à des potentiels de référence et que la borne 55 est polarisée à un niveau déterminé pour qu'une variation de courant I₅₄ ne provienne que d'une variation du potentiel du noeud F, cette variation ne dépend alors que du temps écoulé depuis un instant pendant lequel on stoppe l'alimentation sur la borne 52.

Par la suite, on suppose une extraction d'électrons (application sur la borne 52 d'une tension de réinitialisation positive par rapport à la borne 49) par effet Fowler-Nordheim, mais le fonctionnement qui va être décrit se transpose sans difficulté à une injection d'électrons au noeud F, par exemple par un phénomène dit de porteurs chauds.

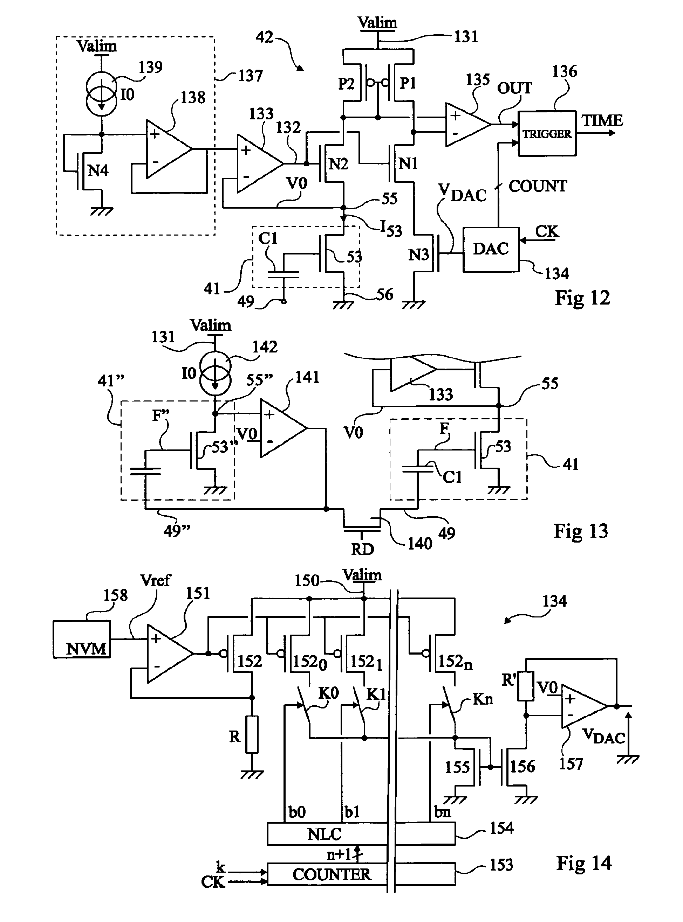

N'importe quel circuit de lecture du potentiel du noeud F peut être envisagé. Par exemple, la valeur mesurée du courant dans le transistor 54 ou d'une tension représentative de ce courant peut être convertie en temps à partir d'une table de conversion ou, après numérisation, à partir d'une loi de conversion établie à partir d'une caractérisation du circuit. Des exemples préférés de circuits de lecture pour interpréter la décharge temporelle et de leur fonctionnement seront décrits en relation avec les figures 12 à 19.

Bien que l'on ait fait référence à une seule tension d'alimentation Valim, des tensions différentes peuvent être utilisées en programmation et en lecture à condition de disposer d'une référence exploitable entre la charge résiduelle et la mesure.

La figure 6 représente une réalisation d'un circuit tel que celui de la figure 5 dans une structure intégrée dérivée d'une architecture de mémoire EEPROM.

Chaque élément ou cellule C2, C1 ou 54 est obtenu à partir d'un transistor à grille flottante connecté en série avec un transistor de sélection T4, T5 ou T6 pour sélectionner, par exemple dans un réseau matriciel de cellules mémoire EEPROM, le circuit électronique de rétention de charges.

Les grilles flottantes des différents transistors constitutifs des éléments C2, C1 et 54 sont interconnectées (ligne conductrice 60) pour former le noeud flottant F. Leurs grilles de commande sont reliées ensemble à une ligne conductrice 61 d'application d'un signal CG de commande en lecture. Leurs sources respectives sont interconnectées à la borne 49 (la masse) et leurs drains respectifs sont reliés aux sources respectives des transistors de sélection T4, T5 et T6.

Les grilles des transistors T4 à T6 sont reliées ensemble à une ligne conductrice 62 d'application d'un signal SEL de sélection du circuit. Leurs drains respectifs D4, D5 et D6 sont connectés à des lignes de bits BL4, BL5 et BL6 commandables individuellement. L'ordre des lignes de bit dans la figure 6 a été illustré de façon arbitraire BL4, BL5 et BL6 mais l'ordre des différents éléments C2, C1 et 54 dans la direction horizontale des rangées (dans l'orientation de la figure) est indifférent.

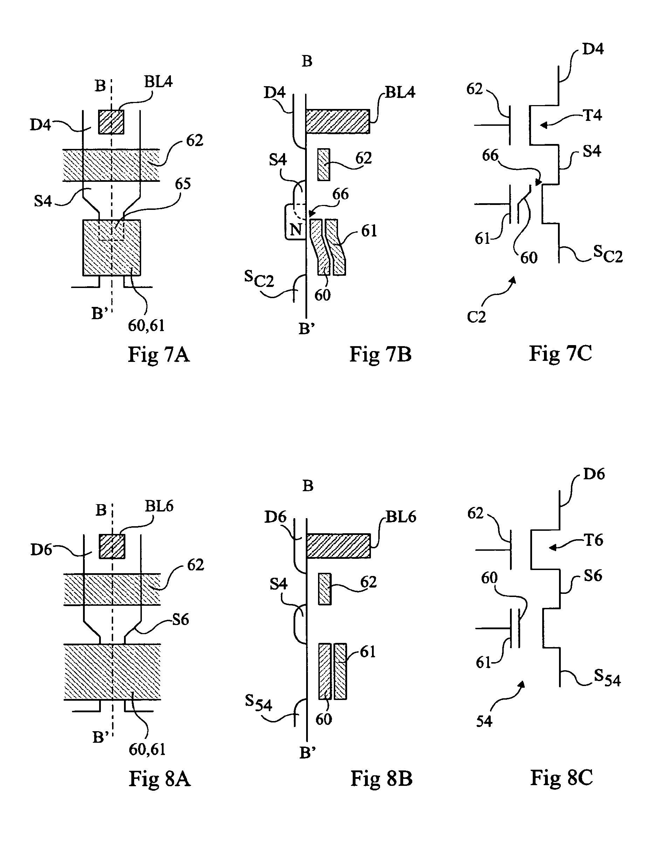

Les figures 7A, 8A et 9A sont des vues de dessus schématiques, respectivement de l'élément C2, de l'élément 54, et de l'élément C1. Les figures 7B, 8B et 9B sont, respectivement, des vues en coupe selon une ligne B-B' des figures 7A, 8A et 9A. Les figures 7C, 8C et 9C représentent les schémas électriques équivalents respectifs des éléments C2, 54 et C1.

Dans l'exemple décrit, on suppose une réalisation de transistor à canal N dans un substrat de silicium de type P. L'inverse est bien entendu possible.

Dans cet exemple de réalisation, on suppose des régions de source et de drain de type N séparées les unes des autres dans la direction des lignes par des zones isolantes. Les grilles flottantes sont réalisées dans un premier niveau conducteur séparé des régions actives par un niveau isolant et les grilles de commande sont réalisées dans un deuxième niveau conducteur séparé du premier niveau conducteur par un deuxième niveau isolant.

Une différence par rapport à un réseau de cellules mémoire EPROM habituel est que les grilles flottantes sont interconnectées par groupe de trois transistors pour réaliser le noeud flottant F. Une autre différence est que les transistors à grille flottante réalisant les différents éléments du circuit sont différents les uns des autres dans leur connexion de drain et de source.

Les figures 7A à 7C illustrent la réalisation de l'élément capacitif C2 de programmation. Il s'agit d'une cellule EEPROM standard dont l'extension 65 de la zone dopée N sous la fenêtre tunnel 66 (figure 7B) permet d'obtenir un plateau dans la zone d'injection de charges. A la manière d'une cellule EEPROM standard, la zone de drain de l'élément C2 est reliée à la source S4 du transistor de sélection T4. La zone de source S_{C2} de l'élément C2 est reliée à la borne 49 (figure 6).

Les figures 8A, 8B et 8C illustrent la réalisation du transistor de lecture 54 dans lequel la fenêtre tunnel a été supprimée de même que, de préférence, la zone implantée habituelle (65, figure 7B) d'une cellule EEPROM. La zone active de l'élément 54, limitée par sa source S₅₄ et son drain S6, est donc similaire à celle d'un transistor MOS normal.

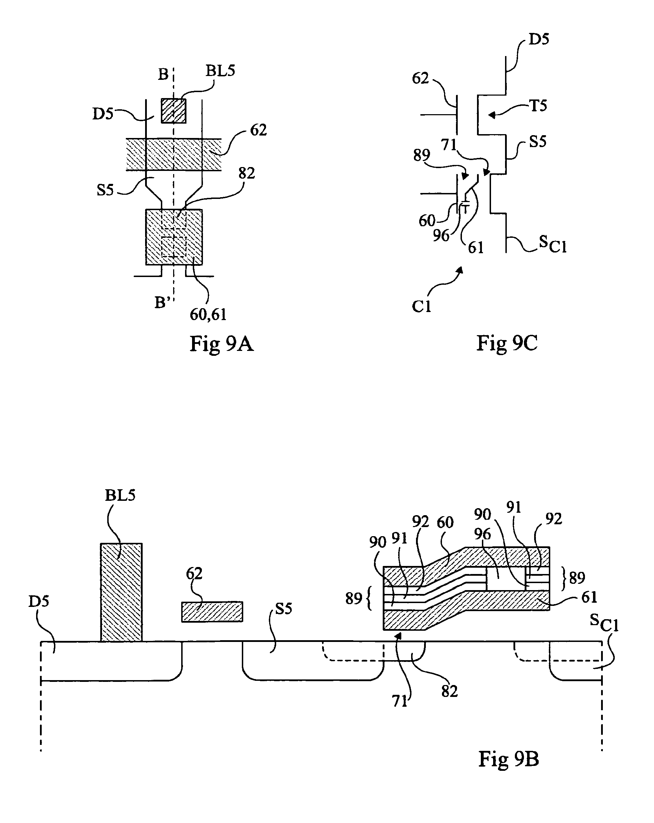

Les figures 9A, 9B et 9C illustrent la réalisation de l'élément capacitif C1 constituant à la fois l'élément de rétention de charges et l'élément de fuite du circuit de rétention de charges. Il s'agit d'une cellule EEPROM standard dont l'extension 82 de la zone dopée N sous la fenêtre tunnel 71 (figure 9B) permet d'obtenir un plateau dans la zone d'injection de charges. De plus, la zone de drain de l'élément C1 est reliée à la source S5 du transistor de sélection T5. La zone de source S_{C1} de l'élément C1 est reliée à la borne 49 (figure 6). Par rapport à une cellule EEPROM standard, une différence consiste à modifier la couche isolante située entre la grille flottante 61 et la grille de commande 60. Cette couche isolante est constituée d'une portion 89 en un matériau isolant identique aux cellules EEPROM standard et d'une portion 96, située, en pratique pour des raisons dimensionnelles, au moins en partie au-dessus de la région de canal du transistor, moins isolante que la portion 89. Par exemple, la portion 89 peut être constituée d'un empilement ONO et la portion 96 peut être constituée d'une simple couche d'oxyde, par exemple d'oxyde de silicium.

La présence de la portion 96, moins isolante que l'isolant utilisé habituellement entre les deux grilles d'un point mémoire EEPROM, permet la fuite de charges stockées dans la grille flottante 61. Les dimensions de la portion 96 définissent alors la vitesse de décharge de la grille flottante 61. Ainsi, une mesure temporelle est facilement réalisable, une fois les dimensions de la portion 96 (et donc la vitesse de décharge de la grille flottante 61) correctement spécifiées, à l'aide d'un circuit de mesure de la charge résiduelle dans la grille flottante 61.

Les représentations des figures 7A à 9C sont schématiques et pourront être adaptées à la technologie utilisée. En particulier, les grilles ont été représentées alignées avec les limites des zones de drain et de source mais un léger recouvrement est souvent présent.

Un avantage de la réalisation au moyen d'une technologie de cellule EEPROM est que le circuit de rétention de charges peut être programmé et réinitialisé en appliquant les mêmes niveaux de tension et les mêmes fenêtres temporelles que ceux utilisés pour effacer ou écrire dans les cellules mémoires EEPROM.

Les connexions respectives des lignes de bit BL4 à BL6 dépendent des phases de fonctionnement du circuit et notamment de la phase de programmation (réinitialisation) ou de lecture.

Le tableau I ci-dessous illustre un mode de mise en oeuvre d'une réinitialisation (SET) et d'une lecture (READ) d'un circuit électronique de rétention de charges tel qu'illustré en figures 6 à 9C.

**Tableau I**

| | SEL | CG | BL4 | BL5 | BL6 | 49 |
|---|---|---|---|---|---|---|
| SET | VPP₁ | 0 | V_{PP2} | HZ | HZ | HZ |
| READ | V_{SEL} | V_{READ} | HZ | HZ | V₅₅ | 0 |

Dans une phase de réinitialisation SET, le signal de sélection SEL est porté à un premier potentiel haut VPP₁ par rapport à la masse pour rendre passants les différents transistors T4 à T6 tandis que le signal CG, appliqué sur les grilles de commande des transistors à grille flottante, reste au niveau bas 0 de façon à ne pas rendre passant le transistor 54. Les lignes de bit BL5 et BL6 restent en l'air (état de haute impédance HZ) tandis qu'un potentiel positif V_{PP2} est appliqué sur la ligne BL4 pour permettre la charge du noeud flottant F. La ligne 49, commune aux sources des transistors à grille flottante, est préférentiellement laissée en l'air HZ.

Pour la lecture READ, les différents transistors de sélection sont activés par le signal SEL à un niveau V_{SEL} et une tension V_{READ} de lecture est appliquée sur les grilles de commande des différents transistors à grille flottante. Les lignes BL4 et BL5 sont dans un état de haute impédance HZ et la ligne BL6 reçoit un potentiel V₅₅ permettant d'alimenter la source de courant de lecture. La ligne 49 est ici connectée à la masse.

Les relations entre les différents niveaux VPP₁, VPP₂, V_{SEL}, V_{READ} et V₅₅ sont, de préférence, les suivantes :
VPP₁ supérieur à VPP₂ ;
V_{SEL} supérieur à V_{READ} ;
V_{READ} du même ordre de grandeur que V₅₅·

Ce qui a été décrit ci-dessus, en relation avec une cellule EEPROM, par "élément du circuit de rétention de charges" peut bien entendu être remplacé par une structure dans laquelle des sous-ensembles de plusieurs cellules identiques sont utilisés en parallèle pour les différents éléments respectifs.

Un circuit électronique de rétention peut être introduit dans n'importe quelle position d'un réseau de cellules mémoire EEPROM standard, ce qui permet de rendre plus difficile sa localisation par un éventuel utilisateur mal intentionné.

En variante, plusieurs circuits peuvent être placés à différents endroits d'un plan mémoire EEPROM. Dans ce cas, on peut prévoir que tous les circuits aient un même temps de décharge ou des circuits ayant des temps de décharge différents les uns des autres.

Selon une autre variante, plusieurs circuits sont répartis dans le plan mémoire mais un seul est utilisé à la fois, selon une séquence déterminée ou aléatoire, contrôlée par un générateur d'adresses. Le cas échéant, les transistors de sélection des cellules formant le circuit de rétention de charges selon un mode de réalisation sont partagés avec des cellules EEPROM normales sur les mêmes lignes de bits, pourvu de prévoir des moyens d'adressage et de commutation adaptés.

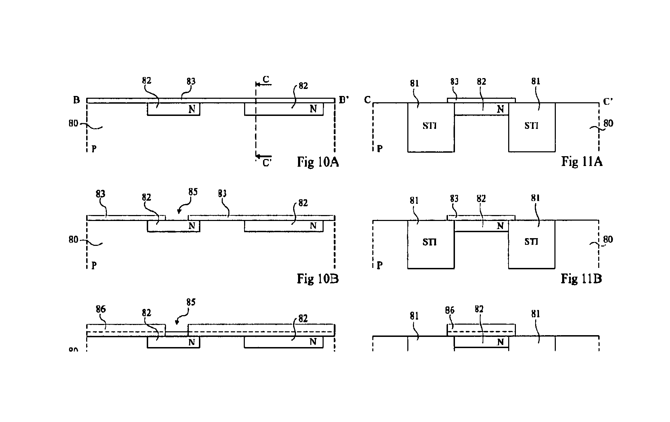

Les figures 10A à 10J sont des vues en coupe selon la ligne B-B' (figure 9A) illustrant des étapes d'un procédé de fabrication d'une cellule EEPROM telle que celle illustrée en figures 9A à 9C. Les figures 11A à 11J illustrent les résultats des figures 10A à 10J dans une vue en coupe selon une ligne C-C' (figure 10A).

On part (figures 10A et 11A) d'un substrat de silicium 80 dopé de type P dans lequel sont formés des caissons d'isolation 81 (STI) des différentes cellules. Des régions 82 dopées de type N, correspondant aux zones 24 de la figure 2, sont formées dans le substrat de silicium 80. Une couche d'oxyde 83 est ensuite formée au-dessus de l'ensemble du transistor de sélection et du point mémoire. A titre d'exemple, la couche 83 peut être en oxyde de silicium.

A l'étape suivante, illustrée en figures 10B et 11B, on a réalisé une gravure de la couche 83 de façon à en éliminer une portion (ouverture 85) au niveau de la zone tunnel du point mémoire. A titre d'exemple, l'ouverture 85 peut être formée par gravure humide à l'aide d'un masque adapté.

A l'étape suivante, illustrée en figures 10C et 11C, on a formé une couche isolante sur la structure des figures 10B et 11B. Ainsi, la région isolante 86 résultant de cette dernière couche et de la couche 82 comprend une portion d'épaisseur plus faible au niveau de l'ouverture 85. On forme ainsi la couche isolante de la grille flottante du point mémoire et la première couche isolante du transistor de sélection.

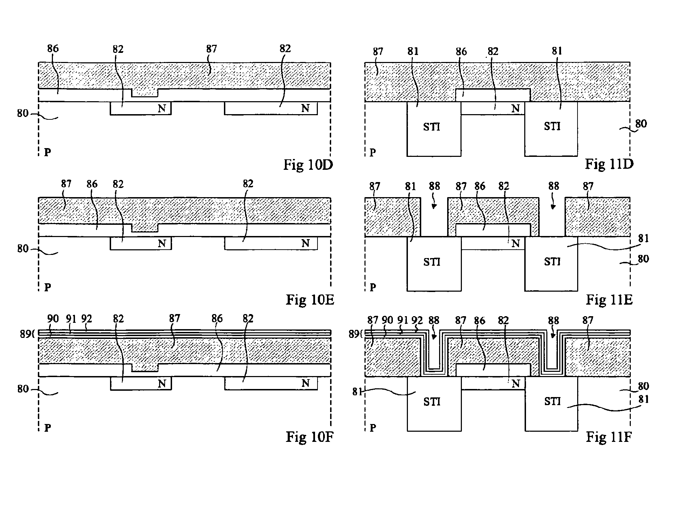

A l'étape suivante, illustrée en figures 10D et 11D, on a formé une couche de silicium polycristallin 87 sur l'ensemble de la structure.

A l'étape suivante, illustrée en figures 10E et 11E, on a réalisé une gravure, à l'aide d'un masque adapté, de la couche de silicium polycristallin 87 (mieux illustrée en figure 11E) de façon à former des ouvertures 88 séparant la cellule EEPROM d'autres cellules formées dans et sur le substrat 80. Les ouvertures 88 sont formées au-dessus des caissons d'isolation 81 (STI).

A l'étape suivante, illustrée en figures 10F et 11F, on a formé, sur la couche 87 et sur les parois et le fond des ouvertures 88, une couche isolante 89. A titre d'exemple, et de façon habituelle, cette couche isolante peut être constituée d'un empilement oxyde-nitrure-oxyde ONO, par exemple d'une première couche d'oxyde de silicium 90, d'une couche de nitrure de silicium 91 et d'une seconde couche d'oxyde de silicium 92.

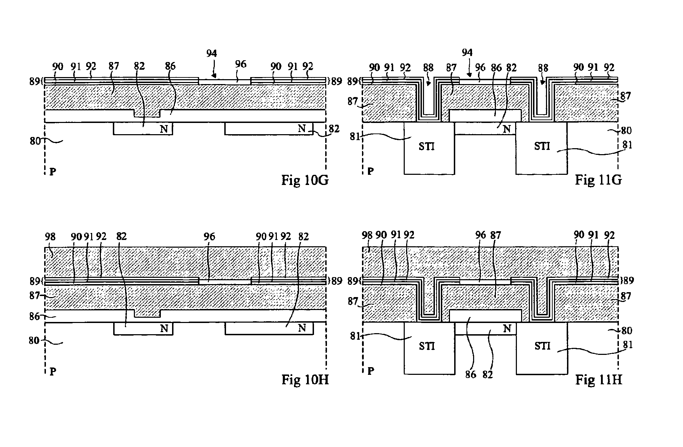

A l'étape suivante, illustrée en figures 10G et 11G, on a réalisé une ouverture 94 dans l'empilement ONO (90, 91, 92) au-dessus, en partie, de la région de canal du point mémoire. A titre d'exemple, cette ouverture peut être obtenue par deux gravures successives : une gravure sèche pour graver la couche d'oxyde 92 et la couche de nitrure 91, puis une gravure humide pour ôter la couche d'oxyde 90. A titre d'exemple, dans le sens de la figure 10G, l'ouverture 94 peut avoir une longueur d'environ 0,6 µm et, dans le sens de la figure 11G, une largeur d'environ 0,3 µm. On a ensuite formé, sur la couche de silicium polycristallin 87 au niveau de l'ouverture 94, une couche isolante 96. La couche isolante 96 peut être obtenue par oxydation de la couche de silicium polycristallin 87.

A l'étape suivante, illustrée en figures 10H et 11H, on a formé une couche de silicium polycristallin 98 sur la structure des figures 10G et 11G.

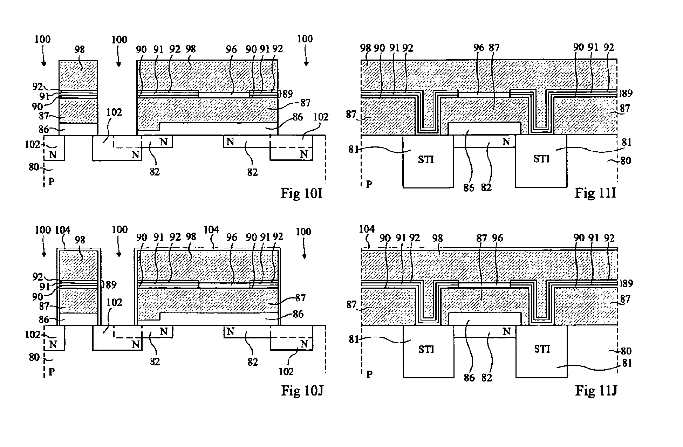

A l'étape suivante, illustrée en figures 10I et 11I, on a délimité les grilles du transistor de sélection et du point mémoire. Pour cela, l'ensemble constitué de la couche de silicium polycristallin 98, de l'empilement ONO (90, 91, 92), de la première couche de silicium polycristallin 87 et de la couche isolante 86, est gravé de façon adaptée (ouvertures 100). On a ensuite formé, au niveau des ouvertures 100, des régions 102 dopées de type N dans le substrat 80 pour former les sources et les drains du transistor de sélection et du point mémoire.

A l'étape suivante, illustrée en figures 10J et 11J, on a formé une fine couche isolante 104, au-dessus et sur les côtés du transistor de sélection et du point mémoire. La couche isolante 104 peut être obtenue par une oxydation thermique. Des espaceurs peuvent ensuite être formés, par tout procédé habituel, de part et d'autre du transistor de sélection et du point mémoire.

Par rapport à un procédé de formation habituel de cellules mémoire EEPROM, ce procédé a l'avantage de ne pas nécessiter d'étapes supplémentaires. En effet, habituellement, lorsque l'on forme des cellules mémoires EEPROM, on forme également des transistors basse tension sur le même substrat. Les transistors basse tension sont formés sur et dans des régions du substrat au niveau desquelles on élimine la couche de silicium polycristallin 87, l'isolant de grille et la grille des transistors basse tension étant, respectivement, formés du matériau isolant de la couche 96 et du silicium polycristallin de la couche 98. Pour obtenir la structure des figures 9A à 9C, il suffit donc de modifier le masque servant habituellement à enlever l'empilement ONO au niveau des transistors basse tension en lui ajoutant une ouverture au niveau de l'ouverture 94. De plus, la structure des figures 9A à 9C a l'avantage d'être complètement compatible avec les autres cellules en termes de programmation, de lecture et d'écriture.

La figure 12 représente un premier mode de réalisation d'un circuit (42, figure 3) de lecture de l'état d'un circuit électronique de rétention de charges contrôlable pour une mesure temporelle. Pour simplifier, le circuit de rétention de charges (figures 4 à 9C) a été symbolisé par un bloc 41 contenant le transistor de lecture (dans cet exemple, un transistor MOS 53, figure 4) et un élément capacitif C1.

Plus généralement, le circuit de rétention de charges pourra être constitué par n'importe quel circuit (par exemple, celui décrit dans la demande internationale WO-A-03/083769 déjà mentionnée).

Le transistor 53 de sortie du circuit 41 est placé dans une première branche d'un montage différentiel comprenant deux branches parallèles de transistors MOS en série entre une borne 131 d'application d'une tension d'alimentation Valim et la masse. Chaque branche comporte, en série, un transistor P1 ou P2 à canal P, un transistor N1 ou N2 à canal N, et un transistor N3 ou 53 à canal N. Les deux transistors P1 et P2 ont leurs grilles reliées à la source du transistor P2 et leurs drains reliés à la borne d'alimentation 131. Les transistors N1 et N2 ont leurs grilles reliées à une borne 132 d'application d'un potentiel de référence. Ce potentiel de référence est fourni, dans cet exemple, par un amplificateur opérationnel 133 recevant, sur une entrée non inverseuse (+), une tension V0, et dont l'entrée inverseuse (-) est reliée à la source du transistor N2 et au drain du transistor 53 (borne 55 du circuit 41). Le montage optionnel 133-N1-N2 permet de fixer un même niveau de tension sur les sources des transistors N1 et N2. La grille du transistor N3 reçoit un signal analogique V_{DAC} fourni par un convertisseur numérique-analogique 134 dont le fonctionnement sera décrit par la suite. Son rôle est de fournir une tension en escalier pour interpréter la charge résiduelle dans le circuit 41.

Les sources respectives des transistors P2 et P1 sont reliées à deux entrées, par exemple non inverseuse (+) et inverseuse (-), d'un comparateur 135 dont la sortie OUT sert à déclencher (TRIGGER 136) la fourniture d'un résultat TIME correspondant à un mot binaire représentatif de l'état COUNT d'un compteur du convertisseur. Ce compteur compte au rythme d'une fréquence d'horloge CK pour générer le signal en escalier, comme on le verra par la suite.

Le circuit de la figure 12 effectue une comparaison entre les courants dans les deux branches. La sortie du comparateur 135 bascule quand le courant dans la branche P1, N1 et N3 devient supérieur (ou inférieur selon l'état initial) au courant dans la branche P2, N2 et 53.

Si la borne 49 est connectée à la masse, pour qu'un courant I₅₃ circule dans la première branche, il faut que la quantité Q_{F}/C_{T} soit supérieure à la tension seuil (Vₜ) du transistor 53, où Q_{F} représente la charge résiduelle dans le circuit 41 et C_{T} la capacité entre le noeud F et la masse (l'élément capacitif C1).

Le potentiel V0 imposé sur la borne 55 par l'intermédiaire de l'amplificateur 133 provient, de préférence, d'un circuit 137 comportant un amplificateur 138 monté en suiveur (sortie reliée à l'entrée inverseuse (-)) dont l'entrée non inverseuse (+) est reliée au drain d'un transistor N4 à canal N, monté en diode. La source du transistor N4 est reliée à la masse tandis que son drain est relié, par une source de courant constant 139 (10), à une borne d'application d'un potentiel positif d'alimentation (par exemple, Valim).

Le circuit 137 génère un niveau V0 tel que le transistor 53 est conducteur de façon à permettre la lecture.

Le courant 10 est choisi en fonction de la consommation souhaitée pour le circuit.

Les transistors à canal N sont appariés ("matched") pour des questions de précision.

De préférence, on impose sur la borne 49 un niveau supérieur au niveau V0. Un objectif est de faire que, même si la cellule 41 est entièrement déchargée, le transistor 53 conduise, et de permettre une lecture sur toute la plage de fonctionnement. Ainsi, la sortie du comparateur 135 bascule lorsque la tension V_{DAC} fournie par le convertisseur 134 dépasse le niveau V0 + Q_{F}/C_{T}.

La figure 13 représente un mode de réalisation préféré dans lequel une structure de référence 41" dont le noeud F'' est en permanence déchargé sert à fixer le potentiel de la borne 49 du circuit 41. Par exemple, un transistor 140 (Pass Gate) relie les bornes 49 et 49'' des circuits 41 et 41''. Un amplificateur 141 a son entrée non inverseuse (+) reliée à la borne 55" du circuit 41 " et, par une source de courant constant 142 (10), à la borne 131 d'application de la tension d'alimentation. L'entrée inverseuse (-) de l'amplificateur 141 reçoit le potentiel de référence V0 généré par un circuit 137 tel que décrit en relation avec la figure 12. Les sources de courant 139 et 142 génèrent un même courant I0. Par conséquent, le potentiel de la borne 55'' est fixé à V0 (imposé par la contre réaction de l'amplificateur 141 et par la grille du transistor 53'' qui est au niveau V0 par le dimensionnement de la source 142). Le potentiel de la borne 49'' est supérieur au niveau V0 même si aucune charge n'est stockée au noeud F''. En effet, lorsqu'un potentiel est appliqué sur la borne 49" (par l'amplificateur 141), le noeud F'' représente le point milieu d'un diviseur capacitif (ne serait-ce qu'en tenant compte de la capacité de grille du transistor 53'' par rapport à la masse). Par conséquent, pour obtenir le niveau V0 au noeud F'', le potentiel de la borne 49" est supérieur au niveau V0.

Pour simplifier la description de la figure 13, le reste de la structure, identique à celle exposée en relation avec la figure 12, n'a pas été détaillé.

Le transistor 140 n'est rendu passant qu'en mode lecture du circuit. Le reste du temps, la borne 49 est soit en l'air, soit connectée à la masse.

Lorsque le transistor 140 est passant, le potentiel de la borne 49' est reporté sur la borne 49. Comme le potentiel de la borne 55 est imposé au niveau V0 par l'amplificateur 133 (dont l'entrée non inverseuse est reliée en sortie du circuit 137), le potentiel du noeud F est au niveau V0 majoré de la charge stockée sur ce noeud. Si la cellule 41 n'est pas chargée, le noeud F est au niveau V0. Si la cellule contient une charge Q_{F}, le potentiel du noeud F est égal à V0+Q_{F}/C_{T}.

Un avantage de ce mode de réalisation où le transistor 140 impose la même tension sur les deuxièmes électrodes accessibles des éléments capacitifs des circuits 41 et 41' est de compenser d'éventuelles dispersions de fabrication.

Qu'il s'agisse du circuit de lecture de la figure 12 ou de la figure 13, il peut être éteint au moyen de commutateurs de commande adaptés (par exemple, déconnectant les branches de l'alimentation et/ou éteignant les sources de courant) en dehors de périodes de lecture.

Côté lecture, en supposant que la charge Q_{F} a une valeur initiale Q_{INIT} notée ici Q(r), une tension V_{DAC} en escalier fournie par le convertisseur 134 comprise entre V0 et V0+Q(r)/C_{T} permet de mesurer le temps.

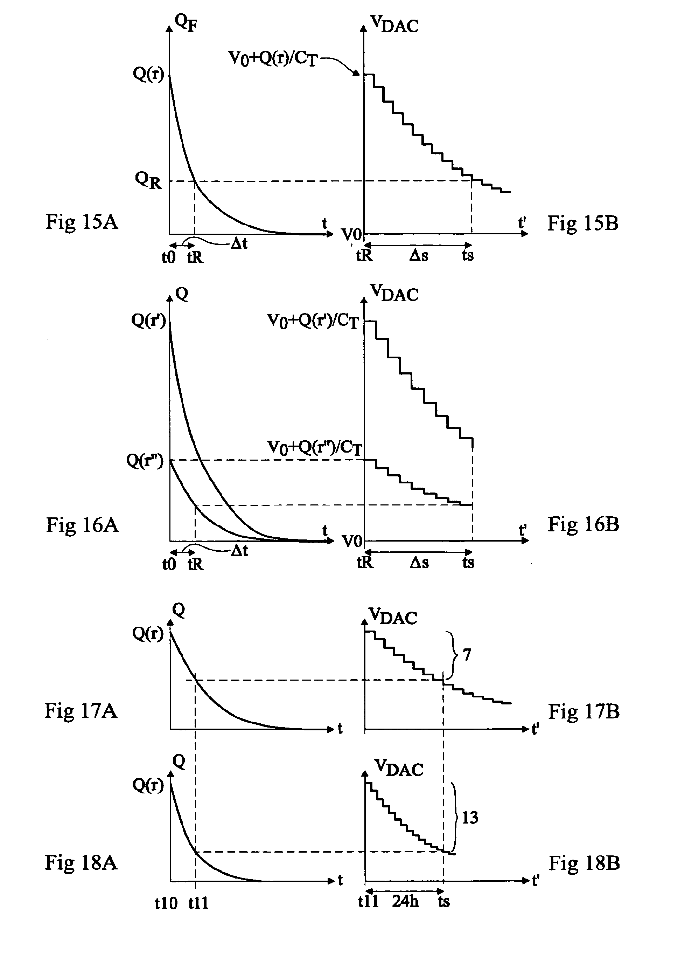

En partant d'un niveau V0+Q(r)/C_{T} et en diminuant progressivement le niveau, le point de basculement du comparateur 135 correspond à une consigne numérique COUNT du convertisseur. Cette consigne est une information sur le temps écoulé depuis la réinitialisation (programmation du circuit de rétention de charges 41) au niveau Q(r). Des exemples seront donnés en relation avec les figures 15A à 18B.

Un avantage est que la fourniture d'un mot numérique est aisément exploitable.

De préférence, le convertisseur numérique-analogique est un convertisseur non linéaire pour compenser l'allure non linéaire de la décharge capacitive du circuit de rétention de charges. En variante, la correction est effectuée en aval par des moyens numériques (de type calculateur) corrigeant le temps écoulé en fonction du compte COUNT auquel le circuit de lecture bascule.

La figure 14 représente un exemple de schéma électrique d'un convertisseur numérique-analogique 134. Une tension de référence Vref est fournie sur un amplificateur différentiel 151 dont la sortie est reliée aux grilles communes de n+2 branches comportant un transistor MOS à canal P 152, 152₀, 152₁, ..., 152ₙ. Un premier transistor 152 a sa source reliée à la masse par une résistance R ainsi qu'à l'entrée inverseuse (-) de l'amplificateur 151 de façon à fixer un courant en Vref/R. Les transistors 152₀ à 152ₙ des n+1 branches suivantes 152₀ à 152ₙ sont de taille croissante d'une branche à la suivante à partir de la taille unitaire du transistor 152₀, égale à celle du transistor 152. Le rapport de taille est de préférence double d'une branche à la suivante pour reproduire le caractère binaire du comptage sur les amplitudes de tension. Les drains respectifs des transistors 152 et 152₀ à 152ₙ sont reliés à une borne 150 d'application d'une tension d'alimentation Valim. Les sources respectives des transistors 152₀ à 152ₙ sont connectées, par des interrupteurs K₀ à Kₙ, au drain d'un transistor MOS à canal N 155 monté en diode et en miroir de courant sur un deuxième transistor à canal N 156. Les sources des transistors 155 et 156 sont connectées à la masse. Le drain du transistor 156 est relié à une entrée inverseuse (-) d'un amplificateur opérationnel 157 dont l'entrée non inverseuse (+) reçoit la tension V0 de référence du circuit de lecture et dont la sortie fournit la tension V_{DAC}. Une résistance R' (par exemple de même valeur que la résistance R) relie la sortie de l'amplificateur 157 à son entrée inverseuse. Les interrupteurs K₀ à Kₙ (par exemple des transistors MOS) sont commandés par les bits respectifs b0, b1, ..., bn d'un circuit de comptage sur n+1 bits. Le circuit de comptage comporte un compteur 153 dont n+1 bits sont envoyés en parallèle sur un circuit de conversion non linéaire 154 (NLC). Les amplificateurs 151 et 157, de même que le compteur 153 et le circuit 154, sont alimentés, par exemple, par la tension Valim.

En supposant les résistances R et R' de même valeur, le courant dans le transistor 156 est égal à k*Vref/R, où k représente l'état COUNT du circuit de comptage. La tension de sortie V_{DAC} est alors donnée par la relation V0 + k*Vref.

D'autres circuits de conversion numérique-analogique non linéaires pourront être utilisés, le circuit de la figure 14 représentant un exemple simple de réalisation d'un tel convertisseur.

Les figures 15A et 15B illustrent un premier mode de fonctionnement d'un circuit de lecture et représentent, respectivement, des exemples d'allure de la charge Q_{F} et de la tension V_{DAC} en fonction du temps.

On suppose une initialisation du circuit de décharge à un niveau Q(r) à un instant t0 et une lecture à un instant tR où la charge résiduelle est Q_{R}.

La non linéarité du convertisseur est définie par le circuit 154 pour compenser la courbe de décharge du circuit de rétention de charges, par exemple à partir de données expérimentales ou de caractérisation. Le circuit 154 est, par exemple, une logique combinatoire convertissant une croissance linéaire de la sortie du compteur 153 en une croissance non linéaire.

Selon l'instant auquel est effectuée la lecture (par exemple instant tR, figure 15A), le courant dans le transistor 53 engendre un basculement de la sortie OUT avec un retard Δs par rapport à l'instant de début de lecture (origine des temps du chronogramme de la figure 15B). Cet intervalle de temps correspond en fait à un nombre fourni par le compteur 153 dans la génération de la tension en escalier envoyée sur la grille du transistor N3 (figure 12). L'état du compteur à l'instant où le signal OUT bascule permet de déduire l'intervalle de temps écoulé Δt entre l'instant de programmation t0 et l'instant de lecture tR, que le dispositif contenant le circuit de rétention de charges ait été ou non alimenté (pourvu que sa borne 52 soit restée en l'air ou isolée). Dans l'exemple des figures 15A et 15B, on suppose une tension V_{DAC} décroissante depuis le niveau V0+Q(r)/C_{T}. Une mesure par tension croissante est bien entendu possible, le point de basculement ts restant le même.

Le rythme des escaliers de la tension V_{DAC} (donc la fréquence CK du compteur 153) est choisi suffisamment rapide par rapport à la vitesse de décharge du circuit 41 pour que l'intervalle Δs entre l'instant de début de lecture tR et l'instant de basculement ts soit négligeable par rapport à l'intervalle réel Δt (tR-t0). L'exagération de la représentation des figures montre cependant l'inverse.

On voit donc que la décharge de l'élément 41 peut s'effectuer sans alimentation, sans pour autant perdre la notion temporelle.

La tension Vref est, de préférence, choisie pour satisfaire à l'équation k*Vref = Q(r)/C_{T}.

De préférence, un ajustement du circuit de lecture est effectué en stockant, dans un registre 158 de mémorisation non volatile (NVM), une valeur Vref de tension ou le nombre k de démarrage du compteur obtenu par caractérisation pour satisfaire la relation ci-dessus, et en utilisant cette valeur à chaque lecture.

Les figures 16A et 16B représentent, dans deux états de charge initiaux Q(r') et Q(r") des exemples de décroissance de la charge en fonction du temps et l'ajustement possible effectué avec le convertisseur numérique-analogique non linéaire.

Le fait d'ajuster la valeur de référence (dans cet exemple, respectivement à des valeurs Q(r')/(k*C_{T}) et Q(r")/(k*C_{T})) rend la mesure temporelle indépendante des conditions de programmation, c'est-à-dire de la charge initiale Q(r') ou Q(r"). Comme on peut le voir sur les figures 16A et 16B, l'instant ts de basculement est le même alors que les niveaux de démarrage du convertisseur sont différents en étant adaptés aux niveaux de charges initiaux.

Selon que la courbe de décharge est connue ou non, il peut être nécessaire d'étalonner chaque circuit 41 de décharge de façon à ce que la non linéarité du convertisseur 134 suive la courbe de décharge.

Les figures 17A, 17B, 18A et 18B illustrent un mode de mise en oeuvre préféré de l'invention dans lequel un étalonnage du circuit de lecture est effectué lors d'une première utilisation, lors d'une initialisation ou en fin de fabrication. Pour cela, le circuit est programmé à un instant t10 puis mesuré à un instant t11 dont l'intervalle par rapport à l'instant t10 est connu (par exemple, un intervalle de 24 heures). On détermine alors le nombre de marches de la décroissance en escalier fourni par le convertisseur numérique-analogique jusqu'à l'instant de basculement ts. Cela permet de définir, pour le circuit concerné, le nombre de pas ou paliers pour l'intervalle de temps connu. Ce nombre peut alors être stocké dans un élément de mémorisation non volatile du dispositif 40.

Les figures 17A et 17B illustrent un premier exemple dans lequel 7 paliers (steps) sont nécessaires pour 24h. L'intervalle de temps (TIME STEP) entre deux paliers est alors de 24/7.

Les figures 18A et 18B illustrent un deuxième exemple dans lequel 13 paliers sont nécessaires pour définir une même plage horaire au moyen d'un autre circuit différent, par exemple, par la valeur de la capacité C1. L'intervalle de temps entre deux paliers est alors de 24/13.

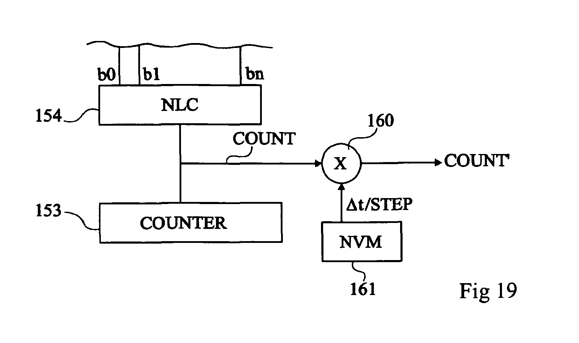

La figure 19 représente, de façon partielle et sous forme de blocs, un exemple d'adaptation possible du circuit de la figure 14 pour obtenir le fonctionnement des figures 17A, 17B, 18A et 18B. Cette modification consiste à utiliser le compte COUNT fourni par le compteur 153 pour le multiplier (multiplieur 160) par un paramètre de conversion du temps (Δt/STEP) stocké en mémoire non volatile (bloc 161, NVM), afin de fournir une valeur de comptage COUNT' modifiée tenant compte des caractéristiques du circuit. Cette valeur COUNT' est fournie au déclencheur 136. Cela revient à appliquer un coefficient de pondération fonction d'une mesure initiale de caractérisation du circuit.

Un avantage de ce mode de réalisation est qu'il ne nécessite aucune modification structurelle du circuit de lecture pour s'adapter à différents circuits de rétention de charges.

Un mode de réalisation trouve de multiples applications dans tout système où l'on souhaite pouvoir mesurer un temps sur un circuit non alimenté. Un exemple d'application particulier concerne la gestion de droits d'accès à des données ou programmes stockés sur des supports numériques. Dans une telle application, un circuit selon un mode de réalisation peut être adjoint au système de mémorisation (clé mémoire ou analogue) non alimenté en permanence, ou être dans un circuit séparé et être réinitialisé par exemple, lors d'un premier chargement des données à protéger.

Un deuxième exemple d'application concerne la mesure d'intervalles temporels entre deux événements quelconques, par exemple dans des applications de type transactionnel.

Bien entendu, la présente invention est susceptible de diverses variantes et modifications qui apparaîtront à l'homme de l'art. En particulier, la mise en oeuvre pratique du circuit de l'invention à partir des indications fonctionnelles données ci-dessus et des besoins de l'application ne pose pas de difficulté. Par exemple, notamment comme elle ne requiert pas d'alimentation permanente, l'invention peut être mise en oeuvre dans des dispositifs sans contact (de type transpondeurs électromagnétiques) qui tirent leur alimentation d'un champ électromagnétique dans lequel ils se trouvent (généré par un terminal).

## Revendications

1. Cellule mémoire EEPROM comprenant un transistor MOS à double grille dont les deux grilles (87, 98) sont séparées par une couche isolante, **caractérisée en ce que** la couche isolante est constituée d'une première portion (89) et d'une seconde portion (96) moins isolante que la première portion, la seconde portion étant située, au moins en partie, au-dessus d'une région de canal du transistor.

2. Cellule mémoire selon la revendication 1, dans laquelle la première portion (89) de la couche isolante est constituée d'un empilement d'une première couche d'oxyde de silicium (90), d'une couche de nitrure de silicium (91) et d'une seconde couche d'oxyde de silicium (92), la seconde portion (96) de la couche isolante étant constituée d'une troisième couche d'oxyde de silicium.

3. Circuit électronique de rétention de charges pour une mesure temporelle, implanté dans un réseau de cellules mémoires de type EEPROM comportant chacune un transistor de sélection en série avec un transistor à double grille, cractérisé en ce qu'il comporte, sur une même rangée de cellules mémoire :
un premier sous-ensemble (C1) formé d'au moins une cellule selon l'une quelconque des revendications 1 ou 2; et
un deuxième sous-ensemble d'au moins une deuxième cellule dont la fenêtre tunnel du transistor à double grille (54) est supprimée,
les grilles flottantes des transistors à double grille des cellules des deux sous-ensembles étant connectées à un noeud flottant (F).

4. Circuit électronique selon la revendication 3, comprenant en outre un troisième sous-ensemble d'au moins une troisième cellule, la grille flottante du transistor à double grille (C2) de la troisième cellule étant connectée au noeud flottant (F), le troisième sous-ensemble servant à injecter ou extraire des charges du noeud flottant dans une phase de programmation ou de réinitialisation.

5. Procédé de mesure d'une information temporelle, **caractérisé en ce que** la charge résiduelle du noeud flottant d'un circuit selon la revendication 3 ou 4 est évaluée à partir du courant dans le transistor à double grille du deuxième sous-ensemble.

6. Procédé de formation d'une cellule mémoire EEPROM comprenant un transistor à double grille de silicium polycristallin, **caractérisé en ce qu'**il comprend, après une étape de formation d'une première grille et avant une étape de formation d'une seconde grille, les étapes successives suivantes :
former, sur la première grille, une première couche de matériau isolant (90, 91, 92) ;
former, dans la première couche de matériau isolant, une ouverture (94) ;
former, dans ladite ouverture (94) et sur la première grille, une seconde couche de matériau isolant (96), la seconde couche étant moins isolante que la première couche isolante.

7. Procédé selon la revendication 6, dans lequel la première couche de matériau isolant est constituée d'un empilement d'une première couche d'oxyde de silicium (90), d'une couche de nitrure de silicium (91) et d'une seconde couche d'oxyde de silicium (92), et la seconde couche de matériau isolant (96) est constituée d'une troisième couche d'oxyde de silicium.

## Patentansprüche

1. Eine EEPROM Zelle, die einen Dual-Gate MOS Transistor aufweist, dessen zwei Gates (87, 98) durch eine Isolationsschicht getrennt sind, **dadurch gekennzeichnet, dass** die Isolationsschicht aus einem ersten Teil (89) und einem zweiten Teil (96) weniger isolierend als der erste Teil aufgebaut ist, wobei der zweite Teil mindestens teilweise oberhalb einer Kanalregion des Transistors angeordnet ist.

2. Die Speicherzelle nach Anspruch 1, wobei der erste Teil (89) der Isolierschicht ausgebildet ist aus einem Stapel einer ersten Siliziumoxydschicht (90), aus einer Siliziumnitridschicht (91) und einer zweiten Siliziumoxydschicht (92), wobei der zweite Teil (96) der Isolierschicht aus einer dritten Siliziumoxydschicht gebildet ist.

3. Eine elektronische Ladungshalteschaltung für eine Zeitmessung implantiert in ein Netzwerk aus Zellen des EEPROM Typs, wobei jede einen Auswahltransistor in Serie mit einem Dual-Gate Transistor aufweist, **dadurch gekennzeichnet, dass** sie auf einer gleichen Reihe von Speicherzellen Folgendes aufweist:
einen ersten Subsatz (C1), ausgebildet aus mindestens einer Zelle irgendeiner der Ansprüche 1 und 2; und
einen zweiten Subsatz aus mindestens einer zweiten Zelle mit dem Tunnelfenster des Dual-Gate Transistors (54) unterdrückt,
wobei die schwimmenden Gates des Dual-Gate Transistors der Zellen der zwei Subsätze mit einem schwimmenden Knoten (F) verbunden sind.

4. Die elektronische Schaltung nach Anspruch 3, ferner einen dritten Subsatz von mindestens einer dritten Zelle aufweisend, wobei das schwimmende Gate des Dual-Gate Transistors (C2) der dritten Zelle verbunden ist mit dem schwimmenden Knoten (F) und der dritte Subsatz verwendet wird, um Ladungen in den schwimmenden Knoten zu injizieren oder zu extrahieren und zwar in einer Programmier- oder Rücksetzphase.

5. Ein Verfahren zur Messung einer Zeitinformation, **dadurch gekennzeichnet, dass** die Restladung des schwimmenden Knotens einer Schaltung gemäß Anspruch 3 oder 4 basierend auf dem Strom in dem Dual-Gate Transistor des zweiten Subsatzes evaluiert wird.

6. Verfahren zur Formung einer EEPROM Zelle, die einen Dual-Gate Polysilizium-Transistor aufweist, **dadurch gekennzeichnet, dass** sie nach einem Schritt des Ausbildens eines ersten Gates und vor einem Schritt der Formung eines zweiten Gates die folgenden, aufeinanderfolgenden Schritte aufweist:
Formen auf dem ersten Gate einer ersten Schicht aus einem Isoliermaterial (90, 91, 92);
Formen in der ersten Isoliermaterialschicht einer Öffnung (94);
Formen in der erwähnten Öffnung (94) und auf dem ersten Gate einer zweiten Isoliermaterialschicht (96), wobei die zweite Schicht weniger isolierend als die erste isolierende Schicht ist.

7. Verfahren nach Anspruch 6, wobei die erste Isoliermaterialschicht auf einem Stapel aus einer ersten Siliziumoxydschicht (90), einer Siliziumnitridschicht (91) und einer zweiten Siliziumoxydschicht (92) geformt ist und wobei die zweite Isoliermaterialschicht (96) aus einer dritten Siliziumoxydschicht geformt ist.

## Claims

1. An EEPROM cell comprising a dual-gate MOS transistor having its two gates (87, 98) separated by an insulating layer, **characterized in that** the insulating layer is formed of a first portion (89) and of a second portion (96) less insulating than the first portion, the second portion being located, at least partly, above a channel region of the transistor.

2. The memory cell of claim 1, wherein the first portion (89) of the insulating layer is formed of a stack of a first silicon oxide layer (90), of a silicon nitride layer (91), and of a second silicon oxide layer (92), the second portion (96) of the insulating layer being formed of a third silicon oxide layer.

3. An electronic charge retention circuit for a time measurement, implanted in a network of EEPROM-type cells each comprising a selection transistor in series with a dual-gate transistor **characterized in that** it comprises, on a same row of memory cells:
a first subset (C1) formed of at least one cell of any of claims 1 and 2; and
a second subset of at least one second cell having the tunnel window of its dual-gate transistor (54) suppressed,
the floating gates of the dual-gate transistors of the cells of the two subsets being connected to a floating node (F).

4. The electronic circuit of claim 3, further comprising a third subset of at least one third cell, the floating gate of the dual-gate transistor (C2) of the third cell being connected to the floating node (F), the third subset being used to inject or extract charges into or from the floating node in a programming or reset phase.

5. A method for measuring a time information **characterized in that** the residual charge of the floating node of a circuit according to claim 3 or 4 is evaluated based on the current in the dual-gate transistor of the second subset.

6. A method for forming an EEPROM cell comprising a dual-gate polysilicon transistor, **characterized in that** it comprises, after a step of forming of a first gate and before a step of forming of a second gate, the successive steps of:
forming, on the first gate, a first layer of an insulating material (90, 91, 92);
forming, in the first insulating material layer, an opening (94);
forming, in said opening (94) and on the first gate, a second insulating material layer (96), the second layer being less insulating than the first insulating layer.

7. The method of claim 6, wherein the first insulating material layer is formed of a stack of a first silicon oxide layer (90), of a silicon nitride layer (91), and of a second silicon oxide layer (92), and the second insulating material layer (96) is formed of a third silicon oxide layer.
